(19) Europäisches Patentamt
European Patent Office
Office européen des brevets

(11) **EP 2 443 661 B1**

(12) **EUROPÄISCHE PATENTSCHRIFT**

(45) Veröffentlichungstag und Bekanntmachung des Hinweises auf die Patenterteilung:
**19.11.2014   Patentblatt 2014/47**

(51) Int Cl.:
*H01L 31/0236* *(2006.01)*    *H01L 31/052* *(2014.01)*
*H01L 31/18* *(2006.01)*

(21) Anmeldenummer: **10723540.0**

(22) Anmeldetag: **07.06.2010**

(86) Internationale Anmeldenummer:
**PCT/EP2010/003396**

(87) Internationale Veröffentlichungsnummer:
**WO 2010/145765 (23.12.2010 Gazette 2010/51)**

(54) **SOLARZELLE UND VERFAHREN ZU DEREN HERSTELLUNG**

SOLAR CELL AND METHOD FOR THE PRODUCTION THEREOF

CELLULE SOLAIRE ET PROCÉDÉ DE FABRICATION DE LADITE CELLULE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **19.06.2009   DE 102009029944**

(43) Veröffentlichungstag der Anmeldung:
**25.04.2012   Patentblatt 2012/17**

(73) Patentinhaber:
• **Fraunhofer-Gesellschaft zur Förderung der angewandten Forschung e.V.**
**80686 München (DE)**
• **Albert-Ludwigs-Universität Freiburg**
**79085 Freiburg (DE)**

(72) Erfinder:
• **BLÄSI, Benedikt**
**79104 Freiburg (DE)**
• **PETERS, Marius**
**72074 Tübingen (DE)**
• **GOLDSCHMIDT, Jan, Christoph**
**79100 Freiburg (DE)**
• **HERMLE, Martin**
**79117 Freiburg (DE)**
• **HAUSER, Hubert**
**79106 Freiburg (DE)**
• **BERGER, Pauline**
**88090 Immenstaad (DE)**

(74) Vertreter: **Lemcke, Brommer & Partner Patentanwälte Partnerschaft mbB Bismarckstraße 16 76133 Karlsruhe (DE)**

(56) Entgegenhaltungen:
WO-A1-2008/100603     US-A- 4 608 451
US-A- 4 620 364       US-A- 5 080 725
US-A1- 2004 021 062

• **PATRICK CAMPBELL ET AL: "Light trapping properties of pyramidally textured surfaces", JOURNAL OF APPLIED PHYSICS, Bd. 62, Nr. 1, 1. Juli 1987 (1987-07-01), Seite 243, XP55004350, ISSN: 0021-8979, DOI: 10.1063/1.339189**
• **C. HEINER. H. MORF: "Submicrometer gratings for Solar energy applications", APPLIED OPTICS, Bd. 34, Nr. 14, 10. Mai 1995 (1995-05-10), XP000002656527, in der Anmeldung erwähnt**
• **KIESS H ED - JAPAN SOCIETY OF APPLIED PHYSICS: "LIGHT TRAPPING IN SOLAR CELLS USING SUBMICRON GRATINGS", PROCEEDINGS OF THE INTERNATIONAL PHOTOVOLTAIC SCIENCE AND ENGINEERING CONFERENCE. KYOTO, NOV. 26 - 30, 1990; [PROCEEDINGS OF THE INTERNATIONAL PHOTOVOLTAIC SCIENCE AND ENGINEERING CONFERENCE], KYOTO, KYOTO UNIVERSITY, JP, Bd. CONF. 5, 26. November 1990 (1990-11-26), Seiten 587-590, XP000215100,**

**Beschreibung**

Die Erfindung betrifft eine Solarzelle, umfassend ein Siliziumsubstrat, eine zur Lichteinkopplung ausgebildete Vorderseite und eine Rückseite gemäß Oberbegriff des Anspruchs 1 sowie ein Verfahren zu deren Herstellung.

Halbleiter-Siliziumsolarzellen dienen zur Umwandlung von auf die Solarzelle auftreffender elektromagnetischer Strahlung in elektrische Energie. Hierzu wird über die zur Lichteinkopplung ausgebildete Vorderseite Licht in die Solarzelle eingekoppelt, so dass durch Absorption in dem Siliziumsubstrat Elektron-Lochpaare generiert werden. An einem pn-Übergang erfolgt die Ladungsträgertrennung. Über elektrische Kontaktierungen eines p- und eines n-Bereiches ist die Solarzelle mit einem externen Stromkreis verbindbar.

Wesentlich für den Wirkungsgrad einer Solarzelle ist neben den elektrischen Eigenschaften die Lichtausbeute. Die Lichtausbeute bezeichnet das Verhältnis zwischen auf die Vorderseite auftreffender elektromagnetischer Strahlung zu der Gesamtgeneration von Elektron-Lochpaaren aufgrund der Lichteinkopplung in der Solarzelle.

Da Silizium ein indirekter Halbleiter ist und damit gegenüber direkten Halbleitern geringere Absorptionswerte für einfallende Strahlung aufweist, ist insbesondere bei Siliziumsolarzellen auch die Verlängerung des Lichtweges innerhalb der Solarzelle relevant, um die Lichtausbeute zu erhöhen: Aufgrund der geringen Absorptionseigenschaften durchdringt ein Teil des längerwelligen Lichtes die Solarzelle und trifft auf die Rückseite der Solarzelle auf. Zur Erhöhung der Lichtausbeute ist es daher bekannt, die Rückseite spiegelnd auszugestalten, so dass ein auf der Rückseite auftreffender Lichtstrahl wieder in Richtung Vorderseite reflektiert wird.

Zur Erhöhung der Lichtausbeute ist es weiterhin bekannt, durch eine Vorderseitentextur, beispielsweise in Form von invertierten Pyramiden, die Lichteinkopplung zu erhöhen, da auftreffende Strahlen auch bei erstmaliger Reflexion mindestens auf eine weitere Vorderseitenoberfläche treffen, so dass die Gesamtlichteinkopplung erhöht wird. Außerdem erfolgt eine schräge Einkopplung der Lichtstrahlen, so dass gegenüber einer planen Oberfläche ein längerer Lichtweg innerhalb des Siliziumsubstrates bis zum Auftreffen auf die Rückseite erzielt wird und darüber hinaus durch den flacheren Winkel bei auftreffen auf die Rückseite eine höhere Wahrscheinlichkeit einer Totalreflexion an der Rückseite vorliegt. Letzteres ist insbesondere von Bedeutung, wenn die Rückseite verspiegelt ist, beispielsweise durch eine Siliziumoxidschicht und eine darüber liegende Metallschicht.

Eine hocheffiziente Siliziumsolarzelle mit einer aus invertierten Pyramiden bestehenden Textur auf der Vorderseite und einer verspiegelten Rückseite ist in DE 195 22 539 A1 beschrieben. Insbesondere bei hocheffizienten Wafer-Siliziumsolarzellen wird durch eine Textur an der Vorderseite und Verspiegelung der Rückseite eine deutliche Erhöhung der Lichtausbeute erzielt. Allerdings werden die auf der Rückseite auftreffenden Photonen nach den Regeln der Strahlenoptik direkt auf die Vorderseite reflektiert, so dass ein Teil der Photonen wieder aus der Solarzelle austritt und für die Energieumwandlung nicht genutzt werden kann. Dies betrifft insbesondere die langwelligen Photonen und der Verlust ist umso ausgeprägter, je dünner die jeweilige Solarzelle ist.

Aufgrund des wesentlichen Anteils des Halbleitermaterials an den Gesamtkosten bei der Herstellung einer Solarzelle steht jedoch die Entwicklung dünnerer, hocheffizienter Siliziumsolarzellen im Vordergrund.

Der Erfindung liegt daher die Aufgabe zugrunde, eine Siliziumsolarzelle und ein Verfahren zur Herstellung einer solchen Solarzelle zu schaffen, bei der die Lichtausbeute, insbesondere bei langwelliger Strahlung, erhöht ist.

Gelöst ist diese Aufgabe durch eine Solarzelle gemäß Anspruch 1 sowie durch ein Verfahren zur Herstellung einer Solarzelle gemäß Anspruch 16. Vorteilhafte Ausgestaltungen der erfindungsgemäßen Solarzelle finden sich in den Ansprüchen 2 bis 15; vorteilhafte Ausgestaltungen des erfindungsgemäßen Verfahrens finden sich in den Ansprüchen 17 bis 19.

Die erfindungsgemäße Solarzelle umfasst ein Siliziumsubstrat, eine zur Lichteinkopplung ausgebildete Vorderseite und eine hierzu gegenüberliegende Rückseite.

Wesentlich ist, dass die Vorderseite zumindest in einem Teilbereich eine Vorderseitentextur aufweist, welche entlang einer Raumrichtung A periodisch ist mit einer Periodenlänge größer 1 $\mu$m und die Rückseite zumindest in einem Teilbereich eine Rückseitentextur aufweist, welche entlang einer Raumrichtung B periodisch ist mit einer Periodenlänge kleiner 1 $\mu$m. Hierbei steht die Raumrichtung A in einem Winkel zwischen 80° und 100° Grad zu der Raumrichtung B. Bei Draufsicht auf die Vorderseite der Solarzelle schließen die Raumrichtung A der periodischen Erstreckung der Vorderseitentextur und die Raumrichtung B der periodischen Erstreckung der Rückseitentextur folglich einen Winkel zwischen 80° und 100° ein.

Eine Textur wird als periodisch bezeichnet, wenn ein Vektor V (V ≠ 0) existiert für den gilt: Eine Translation um V und ganzzahlige Vielfache von V überführt die Textur in sich selbst. Der erzeugende Vektor einer Periode ist der kleinstmögliche Vektor V' der diese Bedingung erfüllt. Periodizität ist nur dann vorhanden, wenn ein solcher kleinstmöglicher Vektor existiert. Für V' gilt, dass ausschließlich Translationen von V' und ganzzahlige Vielfache von V' die Textur in sich selbst überführen. Die Länge von V' ist die Periodenlänge. Gibt es lediglich einen (linear unabhängigen) solchen Vektor, spricht man von linearere Periodizität. Vorzugsweise weisen Vorder- und Rückseitentextur eine lineare Periodizität auf.

Die Raumrichtung A verläuft hierbei parallel zur Vorder- und die Raumrichtung B parallel zur Rückseite.

Die Bezeichnung "parallel" bezieht sich hierbei und im Folgenden auf die jeweils untexturierten Oberflächen von Vorder- und Rückseite, d.h. gedachte plane Ebenen, welche die untexturierte Vorder- bzw. Rückseite darstellen würden. Typischerweise ist die Vorderseite parallel zur Rückseite. Die Angabe "eine Raumrichtung X verläuft parallel zu einer Ebene E" ist so zu verstehen, dass der Vektor, welcher X repräsentiert, in der Ebene E liegt, also alle Punkte von X auch Punkte von E sind.

Im Gegensatz zu den typischen hocheffizienten Siliziumsolarzellen weist die erfindungsgemäße Solarzelle somit sowohl an der Vorder- als auch an der Rückseite eine Textur auf. Wesentlich ist jedoch, dass beide Texturen eine unterschiedliche Periodizität aufweisen. Dies hat folgenden Hintergrund:

Bei Siliziumsolarzellen liegen aufgrund der Absorptionseigenschaften von Silizium die Wellenlängen der effizient in elektrische Energie umwandelbaren elektromagnetischen Strahlung im Bereich von 200 nm bis 1.200 nm, wobei für typische Zelldicken ab etwa 1.000 nm die Absorption stark abnimmt. Periodische Texturen mit einer Periodizität größer 1 $\mu$m weisen somit optische Strukturen auf, die im Wesentlichen größer der Wellenlänge der elektromagnetischen Strahlung sind. Solche optischen Strukturen sind somit im Wesentlichen refraktive Strukturen, d. h. die optischen Eigenschaften lassen sich im Wesentlichen durch Strahlenoptik beschreiben. Hierbei liegt es im Rahmen der Erfindung, dass die Vorderseitentextur mit einer oder mehrerer optischer Schichten, beispielsweise zur Verringerung der Reflexion gegenüber auf die Vorderseite auftreffender Strahlung, beschichtet ist.

Die Periodizität der Rückseitentextur ist hingegen kleiner 1 $\mu$m. Aufgrund der Absorptionseigenschaften von Silizium trifft bei typischen Zelldicken zwischen 10 $\mu$m und 250 $\mu$m lediglich Strahlung mit einer Wellenlänge größer 800 nm nach Durchtritt durch das Siliziumsubstrat auf die Rückseite auf, so dass die Größe der optischen Strukturen der Rückseitentextur im Bereich oder kleiner der Wellenlänge der auftreffenden elektromagnetischen Strahlung im Silizium ist. Hierbei ist zu beachten, dass die Wellenlänge des Lichts bei Propagation im Silizium um einen Faktor verringert wird, der dem Brechungsindex entspricht, d.h. bei Silizium um etwa einen Faktor 3.5.

Die Rückseitentextur ist somit eine im Wesentlichen diffraktive Textur, d. h. dass die optischen Eigenschaften der Rückseitentextur im Wesentlichen nicht durch Strahlenoptik sondern durch Wellenoptik beschrieben werden.

Die Verwendung von diffraktiven Texturen an der Rückseite einer Solarzelle ist grundsätzlich bekannt und beispielsweise in C. Heine, R. H. Morf, Submicrometer gratings for Solar energy applications, Applied Optics, VL. 34, no. 14, May 1995, beschrieben H. Kiess et al, "light trapping in solar cells using submicron gratings" und US 2004021062 beschreiben ebenfalls die Verwendung von diffraktiven Texturen an der Rückseite von Solarzellen. Bei den aus dem Stand der Technik bekannten Siliziumsolarzellen erfolgt jedoch keine Kombination von refraktiven und diffraktiven Texturen. Untersuchungen des Anmelders haben ergeben, dass der wesentliche Nachteil darin begründet ist, dass bei Kombination einer Vorderseite mit einer refraktiven Textur und einer Rückseite mit einer diffraktiven Textur das Licht unter verschiedenen Richtungen und mit verschiedenen relativen Orientierungen auf die Rückseite auftrifft, so dass ein Teil der Strahlen in einem nicht optimalen Winkel auf die Rückseitentextur auftrifft. Weiterhin treffen die von der Rückseite gebeugten Strahlen zumindest teilweise unter ungünstigen Winkeln auf die Vorderseite auf, so dass eine Auskopplung dieser Strahlen erfolgt und somit die Lichtausbeute verringert wird. Diese Effekte sind insbesondere dann ausgeprägt, wenn die Vorderseitentextur eine dreidimensionale Textur ist, wie beispielsweise die im Stand der Technik bekannte Textur mittels invertierter Pyramiden.

Aus diesem Grund erschienen bisher diffraktive Texturen an der Rückseite bei Solarzellen mit refraktiven Texturen an der Vorderseite nicht sinnvoll.

Die erfindungsgemäße Solarzelle weist jedoch an der Vorderseite eine sich in Raumrichtung A periodisch erstreckende Textur auf. Hierdurch werden die möglichen Richtungen und Orientierungen, mit denen Lichtstrahlen auf die Rückseite auftreffen, reduziert. Weiterhin steht die Raumrichtung B, in der sich die Rückseitentextur periodisch erstreckt, in einem Winkel zwischen 80° und 100° zu der Raumrichtung A. Für den Großteil der möglichen Strahlengänge wird hierdurch der zuvor beschriebene negative Effekt einer Lichtwegsverkürzung ausgeschlossen.

Bei der erfindungsgemäßen Solarzelle ist somit erstmals die Kombination einer im Wesentlichen refraktiven Vorderseitentextur mit einer im Wesentlichen diffraktiven Rückseitentextur derart realisiert, dass die Vorteile beider Texturierungsarten vereint und negative Effekte aufgrund von für die diffraktive Rückseitenstruktur nicht optimalen Einfallswinkeln und der Auskopplung der an der Rückseite gebeugten Strahlen an der Vorderseitentextur ausgeschlossen sind:

Aufgrund der Ausbildung der Vorderseitentextur als eine sich in Raumrichtung A periodisch erstreckende Textur erfolgt zumindest bei senkrecht auf die Vorderseite auftreffenden Strahlen eine Einkopplung im Wesentlichen in einer Ebene, die durch die Raumrichtung A und eine senkrecht zur Vorderseite stehende Raumrichtung aufgespannt ist. Hierdurch ist es möglich, die diffraktive Rückseitentextur derart zu optimieren,

- dass die an der Rückseite gebeugten Strahlen nahezu parallel zu der Rückseite propagieren, wodurch eine Lichtwegverlängerung erzielt wird,

- dass die an der Rückseite gebeugten Strahlen an der Vorderseite derart auftreffen, dass eine Totalreflexion an der Vorderseite und damit ebenfalls eine Lichtwegverlängerung erzielt wird und

- dass an der Rückseite keine veriustbehafteten Mehrfachreflexionen auftreten.

Eine solche Optimierung wird zum Teil bereits dadurch erreicht, dass die Raumrichtung B, in der sich die Rückseitentextur periodisch erstreckt, in einem Winkel zwischen 80° und 100° zu der Raumrichtung A steht. Eine erhöhte Optimierung wird durch einen Winkel zwischen 85° und 95° erreicht, vorzugsweise einen Winkel von 90°, d.h. dass die beiden Raumrichtungen im rechten Winkel zueinander stehen.

Sogenannte "cross-grooved" Solarzellen, wobei die Raumrichtung B, in der sich die Rückseitentextur periodisch erstreckt, im rechten Winkel zu der Raumrichtung A, in der sich die Vorderseitentextur periodisch erstreckt, steht, sind im Stand der Technik bekannt (wie z.B. P. Campbell et al, "light trapping properties of pyramidally textured surfaces", US 4608451, US 4620364, US 5080725 oder WO 200810063 beschrieben), dennoch nicht in Kombination mit einer refraktiven Vorderseitentextur und einer diffraktiven Rückseitentextur.

Vorteilhafterweise bedecken Vorder- und Rückseitentextur jeweils im Wesentlichen die gesamte Vorder- und Rückseite der Solarzelle, ggf. mit Unterbrechungen z.B. zur Aufbringung von Metallisierungsstrukturen. Ebenso liegt es im Rahmen der Erfindung, dass lediglich ein oder mehrere Teilbereiche von Vorder- und/oder Rückseite eine Textur aufweisen. In dieser Ausführungsform sind Vorder- und Rückseitentextur vorzugsweise an einander gegenüberliegenden Teilbereichen der Vorder- und Rückseite angeordnet.

Es liegt im Rahmen der Erfindung, dass gegebenenfalls die Solarzelle an Vorder- und/oder Rückseite in mehrere Teilbereiche aufgeteilt ist, die jeweils eine sich periodisch erstreckende Textur aufweisen. Wesentlich ist jedoch, dass in anderen Raumrichtungen als die Raumrichtung der periodischen Erstreckung gegebenenfalls vorliegende Wiederholungen eine wesentlich größere Periodizität aufweisen, verglichen der Periodizität der sich periodisch erstreckenden Textur.

Vorzugsweise weist daher die Vorderseitentextur in einer zu der Raumrichtung A senkrecht stehenden Raumrichtung A' keine Periodizität oder eine Periodizität mit einer Periodenlänge von mindestens 30 $\mu$m, vorzugsweise mindestens 50 $\mu$m auf. Die Raumrichtung A' verläuft ebenfalls parallel zur Vorderseite. Weiterhin ist es vorteilhaft, wenn die die Vorderseitentextur in Raumrichtung A' keine Periodizität oder eine Periodizität mit einer Periodenlänge aufweist, die mindestens dem 5-fachen, vorzugsweise mindestens dem 10-fachen, im Weiteren vorzugsweise mindestens dem 15-fachen der Periodenlänge der Vorderseitentextur in Raumrichtung A entspricht.

Weiterhin weist vorzugsweise die Rückseitentextur in einer zu der Raumrichtung B senkrecht stehenden Raumrichtung B' keine Periodizität oder eine Periodizität mit einer Periodenlänge von mindestens 5 $\mu$m, vorzugsweise mindestens 10 $\mu$m, im Weiteren vorzugsweise mindestens 30 $\mu$m, insbesondere mindestens 50 $\mu$m auf. Die Raumrichtung B' verläuft ebenfalls parallel zur Rückseite. Weiterhin ist es vorteilhaft, wenn die die Rückseitentextur in Raumrichtung B' keine Periodizität oder eine Periodizität mit einer Periodenlänge aufweist, die mindestens dem 5-fachen, vorzugsweise mindestens dem 10-fachen, im Weiteren vorzugsweise mindestens dem 15-fachen der Periodenlänge der Rückseitentextur in Raumrichtung B entspricht.

Weiterhin ist es vorteilhaft, wenn die Texturen in den Raumrichtungen A' bzw. B' keine oder nur einer geringfügige Höhenänderung aufweisen, d.h. dass sich das Höhenprofil der Textur in dieser Raumrichtung nicht oder nicht wesentlich ändert.

Vorzugsweise ändert sich daher die Höhe der Vorderseitentextur in der Raumrichtung A' um nicht mehr als 2 $\mu$m, insbesondere weist in der Raumrichtung A' die Vorderseitentextur eine in etwa konstante Höhe auf.

Weiterhin ändert sich daher die Höhe der Rückseitentextur in der Raumrichtung A' vorzugsweise um nicht mehr als 50 nm, insbesondere weist in der Raumrichtung A' die Rückseitentextur eine in etwa konstante Höhe auf.

Die vorgenannten Bedingungen vereinfachen den Herstellungsprozess und verhindern nachteilige optische Effekte.

Zur Vereinfachung und Kostenreduzierung der Herstellung der erfindungsgemäßen Solarzelle ist es insbesondere vorteilhaft, dass die Vorderseitentextur eine sich in Raumrichtung A' linear erstreckende Textur ist und/oder die Rückseite eine sich in Raumrichtung B' linear erstreckende Textur ist. Solche Strukturen werden auch Grabenstrukturen genannt. Die Raumrichtung der periodischen Erstreckung steht in diesem Fall somit senkrecht zu den linearen oder grabenartigen Texturelementen. Insbesondere ist es vorteilhaft dass die Vorderseitentextur in Raumrichtung A' und/oder die Rückseitentextur in Raumrichtung B' jeweils eine in etwa konstante Querschnittsfläche und in etwa konstante Querschnittsflächenform aufweisen.

Es liegt im Rahmen der Erfindung, dass in Teilbereichen an der Vorder- und/oder Rückseite die Textur unterbrochen ist, beispielsweise zur Aufbringung einer Metallisierungsstruktur zur elektrischen Kontaktierung des Siliziumsubstrates.

Die Höhe der Vorderseitentextur, d.h. der maximal Höhenunterschied der optisch relevanten Fläche der Vorderseitentextur, beträgt vorzugsweise zwischen 2 $\mu$m und 50 $\mu$m, insbesondere zwischen 5 $\mu$m und 30 $\mu$m. Hierdurch wird eine Optimierung der refraktiven optischen Wirkung und der kostengünstigen Herstellung er-

Die Höhe der Rückseitentextur, d.h. der maximal Höhenunterschied der optisch relevanten Fläche der Rückseitentextur, beträgt vorzugsweise zwischen 50 nm und 500 nm, insbesondere zwischen 80 nm und 300 nm. Hierdurch wird eine Optimierung der diffraktiven optischen Wirkung und der kostengünstigen Herstellung erzielt.

Um die elektrischen Eigenschaften der Solarzelle nicht zu beeinträchtigen und eine einfache elektrische Kontaktierung mittels metallischer Strukturen zu ermöglichen ist es vorteilhaft, wenn die Vorderseitentextur eine Periodizität kleiner 40 μm, vorzugsweise kleiner 20 μm aufweist.

Zur Erzielung optimaler optischer Eigenschaften der Rückseite ist es alternativ und/oder zusätzlich vorteilhaft, dass die Rückseitentextur eine Periodizität größer 50 nm, vorzugsweise größer 100 nm aufweist.

Vorzugsweise ist die Vorderseitentextur direkt an der Vorderseite des Siliziumsubstrates erzeugt. Ebenso liegt es im Rahmen der Erfindung, eine oder mehrere Schichten auf der Vorderseite des Siliziumsubstrates aufzubringen und die Textur an einer oder mehrerer dieser Schichten zu erzeugen. Gleiches gilt für die Rückseitentextur.

Die Periodizitäten der Vorderseitentextur und der Rückseitentextur sind vorzugsweise derart gewählt, dass die Vorderseitentextur eine vorwiegend refraktive Textur und die Rückseitentextur eine vorwiegend diffraktive Textur ist. Vorteilhafterweise ist die Periodizität der Vorderseite daher größer als 3 μm, insbesondere größer als 5 μm. Alternativ oder zusätzlich ist vorteilhafterweise die Periodizität der Rückseitentextur kleiner als 800 nm, vorzugsweise kleiner als 600 nm.

Zur optimalen Erhöhung der Lichtausbeute überdeckt die Vorderseitentextur vorteilhafterweise mindestens 30%, insbesondere mindestens 60%, im Weiteren mindestens 90% der Vorderseite, ggf. mit Unterbrechungen z.B. für Metallisierungen. Gleiches gilt für die Rückseitentextur an der Rückseite.

Zur Erzeugung hocheffizienter Siliziumsolarzellen ist die Verwendung eines monokristallinen Siliziumsubstrates üblich. In diesem Fall ist die Vorderseitentextur vorzugsweise durch lineare Texturelemente ausgebildet, welche jeweils eine dreieckige Querschnittsfläche aufweisen.

Ebenso ist die Verwendung multikristalliner Siliziumwafer vorteilhaft. Hier sind die erzielten Wirkungsgrade zwar etwas niedriger im Vergleich mit monokristallinen Solarzellen, die Materialkosten sind jedoch deutlich geringer. Bei Verwendung multikristalliner Siliziumwafer wird vorteilhafterweise eine Vorderseitentextur mit einer Querschnittsfläche, die gebogene oder runde Ränder aufweist, erzeugt.

Aufgrund der unterschiedlichen Ätzgeschwindigkeiten in verschiedenen Raumrichtungen bei Ätzen eines monokristallinen Siliziumsubstrates weist die Rückseitentextur vorzugsweise lineare Texturelemente auf, wie beispielsweise in der zuvor genannten Veröffentlichung J. Heine; R. H. Morf, a a O., auf Seite 2478 zu Figur 3 beschrieben. Häufig ist jedoch die Herstellung solcher Texturelemente mit sägezahnförmigem Querschnitt äußerst aufwendig und kostenintensiv. Vorzugsweise wird die Sägezahnform daher durch eine Treppenform angenähert, wie in der genannten Veröffentlichung auf gleicher Seite zu Figur 4 beschrieben. Die genannte Veröffentlichung wird per Referenznahme in diese Beschreibung eingebunden.

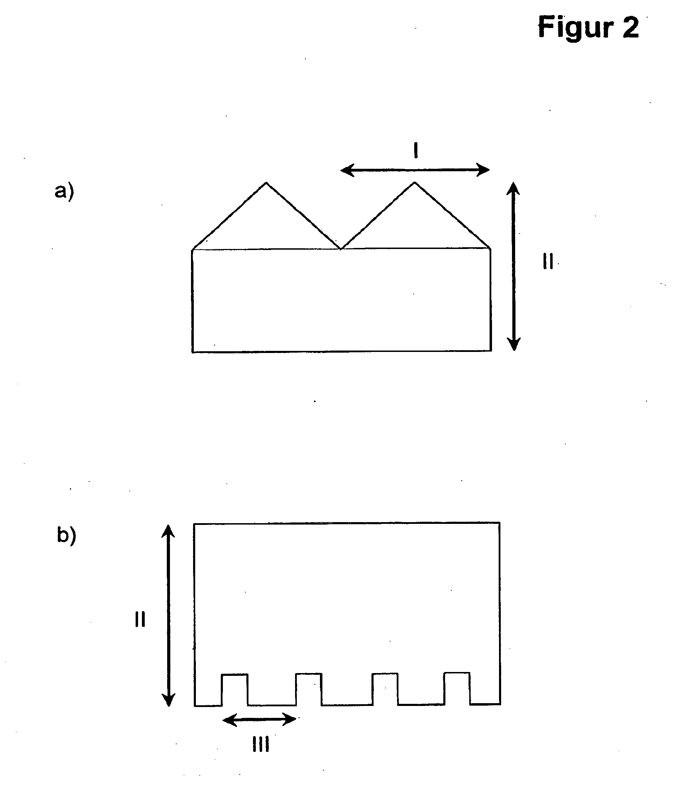

Eine besonders einfach und damit kostengünstig herstellbare diffraktive Textur stellt eine zinnenförmige Rückseitentextur mit senkrecht zueinander stehenden Flanken dar, wie beispielsweise in der vorgenannten Veröffentlichung zu Figur 2 beschrieben.

Ebenso liegen sinusförmige, diffraktive Texturen sowie sägezahnförmige, diffraktive Texturen im Rahmen der Erfindung.

Aufgrund der geringen Strukturgrößen der Rückseitentextur können die vorgenannten vorteilhaften Querschnittsformen häufig prozessbedingt nur näherungsweise erzielt werden, insbesondere treten häufig Rundungen an den Kanten der Strukturen auf.

Zur Vereinfachung der weiteren Prozessschritte an der Rückseite der erfindungsgemäßen Solarzelle, insbesondere des Aufbringens einer Metallisierungsstruktur ist es vorteilhaft, dass an der Rückseite eine Rückseitenschicht, vorzugsweise eine dielektrische Schicht auf die Rückseitentextur aufgebracht ist. Hierbei wird die Rückseitentextur vollständig von der dielektrischen Schicht bedeckt, so dass eine plane Fläche an der Rückseite für die nachfolgenden Prozessschritte vorliegt. Insbesondere ist es vorteilhaft, dass die Rückseitenschicht eine elektrisch isolierende Schicht ist und auf die Rückseitenschicht eine Metallisierung, vorzugsweise ganzflächig, aufgetragen wird.

Hierdurch ist es in einfacher Weise möglich, durch lokale Aufschmelzung, beispielsweise mittels eines Lasers, lokale elektrisch leitende Verbindungen zwischen Metallschicht und Siliziumsubstrat zu erzeugen.

Im Unterschied zu den vorbekannten diffraktiven Rückseitentexturen treffen bei der erfindungsgemäßen Solarzelle die Strahlen aufgrund der Vorderseitentextur typischerweise nicht senkrecht auf die Rückseite auf. Vorzugsweise ist die Rückseitentextur daher für einen nicht senkrechten Einfall der Strahlen auf die Rückseite optimiert, insbesondere, in dem für einen gegebenen Einfallswinkel θ auf die Rückseite die Periodizität $\Lambda_R$ der Rückseitentextur gemäß Formel 1 gewählt ist:

$$\Lambda_R = \frac{\lambda}{n\cos(\theta)} \ (\text{Formel 1}),$$

mit dem Brechungsindex n des Siliziumsubstrates und der Wellenlänge λ des auf die Rückseite auftreffenden Strahles. Vorzugsweise ist λ hierbei die größte relevante Wellenlänge, d.h. die größte noch relevant zur Ladungsträgergeneration in der Solarzelle beitragende Wellenlänge des Spektrums der auf die Solarzelle auftreffenden Strahlung und der Winkel θ der aufgrund der Vorderseitentextur vorliegende Haupteinfallswinkel der Strahlen auf die Rückseite. Formel 1 liefert insbesondere bei einem Winkel von 90° zwischen der periodischen Erstreckung von Vorder- und Rückseitentextur und/oder bei einer Vorderseitentextur mit dreieckigen Querschnittsflächen eine optimale Periodizität für die Rückseitentextur.

Bei Verwendung eines monokristallinen Siliziumwafer und Ätzen der Vorderseitentextur ergibt sich aufgrund der Kristallorientierung typischerweise ein Einfallswinkel θ auf die Rückseite von 41,4°. Weiterhin wird für Silizium die größte relevante Wellenlänge vorzugsweise mit λ = 1100 nm gewählt, denn dies stellt eine Wellenlänge nahe der Bandlücke dar. Mit einem Brechungsindex von $n = 3,5$ für Silizium ergibt sich in dieser vorzugsweisen Ausführungsform somit eine Periodizität von $\Lambda_R = 419$ nm.

Die Erfindung umfasst weiterhin ein Verfahren zur Herstellung einer Solarzelle, umfassend ein Siliziumsubstrat, mit einer Vorder- und einer Rückseite, gemäß Anspruch 13. Das erfindungsgemäße Verfahren umfasst folgende Verfahrensschritte:

> In einem Verfahrensschritt A wird eine Vorderseitentextur zumindest an einem Teilbereich der Vorderseite erzeugt, wobei die Vorderseitentextur in einer Raumrichtung parallel zu der Vorderseite invariant ist und in einer dazu senkrechten Raumrichtung A parallel zu der Vorderseite eine Periodizität größer 1 μm aufweist.

Vorzugsweise erfolgt anschließend ein Reinigen der Rückseite des Halbleitersubstrates.

In einem Verfahrensschritt B wird eine Rückseitentextur zumindest an einem Teilbereich der Rückseite erzeugt, wobei die Rückseitentextur in einer Raumrichtung parallel zu der Rückseite invariant ist und in einer dazu senkrechten Raumrichtung B parallel zu der Rückseite eine Periodizität kleiner 1 μm aufweist.

Hierbei werden Vorder- und Rückseitentextur derart ausgebildet, dass die Raumrichtung A in einem Winkel zwischen 80° und 100° zu der Raumrichtung B steht.

Vorzugsweise umfasst die Erzeugung der Rückseitentextur in Verfahrensschritt B folgende Verfahrensschritte:

> In einem Verfahrensschritt B1 wird eine ätzresistente Maskierungsschicht auf die Rückseite aufgebracht. Anschließend wird in einem Verfahrensschritt B2 die Maskierungsschicht mittels eines Prägeverfahrens strukturiert. Ein solches Prägeverfahren ist beispielsweise in US 4,731,155 beschrieben. Anschließend erfolgt in einem Verfahrensschritt B3 ein Ätzen der nicht durch die Maskierungsschicht bedeckten Bereiche der Rückseite.

Danach wird die Maskierungsschicht wieder entfernt.

In einer weiteren vorteilhaften Ausgestaltung des erfindungsgemäßen Verfahrens wird anschließend ein Schritt C eine Rückseitenschicht, vorzugsweise eine dielektrische Schicht auf die Rückseitentextur aufgebracht, wobei die Rückseitenschicht die Rückseitentextur vollständig bedeckt.

Die Rückseitenschicht wird vorzugsweise ganzflächig mit einer Metallschicht bedeckt. Zur Herstellung der elektrischen Kontaktierung der Rückseite kann dann auf ein bereits bekanntes Verfahren der lokalen Aufschmelzung mittels eines Lasers ("Laser-Fired-Contacts (LFC)") zurückgegriffen werden, wie in DE 100 46 170 A1 beschrieben.

Die Struktur der erfindungsgemäßen Solarzelle kann auf die vorbekannten Solarzellenstrukturen übertragen werden, wobei Vorder- und Rückseite die Texturen gemäß der erfindungsgemäßen Solarzelle aufweisen. Typischerweise weist die erfindungsgemäße Solarzelle zumindest an der Vorderseite des Siliziumsubstrates einen Emitter auf und auf der Vorderseite eine Metallisierung zur Emitterkontaktierung sowie auf der Rückseite eine Metallisierung zur Basiskontaktierung. Insbesondere ist ein Aufbau analog zu der in DE 195 22 539 A1 beschriebenen Solarzelle vorteilhaft, wobei an Vorder- und Rückseite des Siliziumsubstrates die Texturen gemäß der erfindungsgemäßen Solarzelle ausgebildet sind. Ebenso kann die erfindungsgemäße Solarzelle analog zu an sich bekannten Rückseitenkontaktzellen, insbesondere EWT-Solarzellen (wie z.B. in US5468652 beschrieben) oder MWT-Solarzellen (wie z.B. in EP985233 beschrieben) ausgebildet sein.

Weitere Merkmale und vorteilhafte Ausgestaltungen ergeben sich aus dem nachfolgend beschriebenen und in den Figuren dargestellten Ausführungsbeispiel. Dabei zeigt:

> Figur 1 einen Teilausschnitt einer erfindungsgemäßen Solarzelle in schematischer, perspektivischer Darstellung und

> Figur 2 Schnittdarstellungen zu Figur 1.

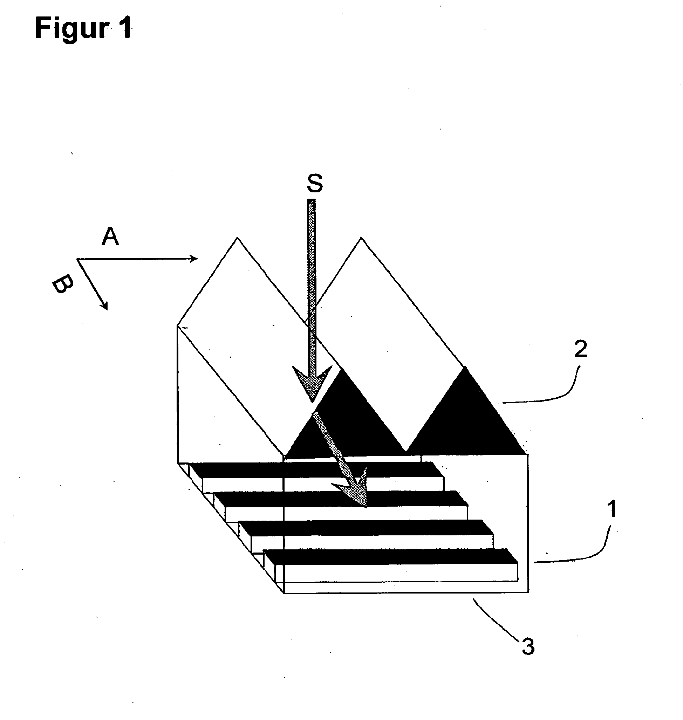

Die in Figur 1 dargestellte Solarzelle umfasst ein Siliziumsubstrat 1 mit einer Vorderseite 2 und einer Rückseite 3.

Das Siliziumsubstrat ist ein monokristalliner Siliziumwafer. An der Vorderseite 2 ist eine refraktive Vorderseitentextur mit dreieckigen Querschnittsflächen und an der Rückseite 3 ist eine diffraktive Rückseitentextur ausgebildet, welche einen zinnenförmigen Querschnitt aufweist.

Die Vorderseitentextur ist als eine lineare Textur mit parallel zueinander liegenden Texturelementen ausgebildet, wobei sich die Textur periodisch entlang der mit A bezeichneten Raumrichtung erstreckt. Die Rückseitentextur ist ebenfalls als lineare Struktur ausgebildet, wobei sich die Textur periodisch entlang der mit B bezeichneten Raumrichtung erstreckt. Die Raumrichtungen A und B stehen in einem Winkel von 90° zueinander.

Bei dem in Figur 1 dargestellten Ausführungsbeispiel einer erfindungsgemäßen Solarzelle wird ein senkrecht auf die Vorderseite 1 auftreffender Strahl S an der Vorderseite 2 schräg in das Siliziumsubstrat 1 eingekoppelt. Der Strahl S verläuft dabei in dem Siliziumsubstrat in einer Ebene, die parallel zu den linearen Strukturen an der Rückseite liegt und damit senkrecht zu der periodischen Erstreckung (Raumrichtung B) der Rückseitentextur.

Der an der Rückseite gebeugte Strahl propagiert hingegen derart, dass bei Auftreffen des Strahls im Siliziumsubstrat 1 an der Vorderseite 2 eine Totalreflexion erfolgt und somit kein Strahlanteil ausgekoppelt wird.

Die Darstellung in Figur 1 dient der Verdeutlichung der geometrischen Anordnung der Texturen an Vorder- und Rückseite. Die Größe der Texturen zueinander und in Bezug auf die dargestellte Gesamtdicke der Solarzelle sind zur besseren Darstellbarkeit nicht maßstabsgerecht. Weiterhin sind zur besseren Darstellbarkeit die dreieckigen Schnittflächen der Vorderseitentextur und die tiefliegenden Oberflächen der Rückseitentextur ausgefüllt dargestellt.

In Figur 2 sind Schnittzeichnungen zu Figur 1 dargestellt. Figur 2a) zeigt hierbei einen Schnitt senkrecht zur Vorderseite 2 und parallel zur Raumrichtung A; Figur 2b) einen Schnitt senkrecht zur Vorderseite 2 und parallel zur Raumrichtung B.

Die in dem Ausführungsbeispiel dargestellte Solarzelle besitzt ein Siliziumsubstrat mit einer Gesamtdicke II von 250 $\mu$m, wobei die Höhe der Texturelemente an der Vorderseite etwa 14 $\mu$m beträgt. Die Höhe der Texturelemente an der Rückseite beträgt etwa 0,1 $\mu$m.

Die Vorderseitentextur weist eine Periodizität von 10 $\mu$m auf, d.h. die Strecke I in Figur 2a) beträgt 10 $\mu$m. Die Periodizität der Rückseitentextur ist etwa 419 nm, d.h. die Strecke III ind Figur 2b) beträgt etwa 419 nm.

**Patentansprüche**

1. Solarzelle,
   umfassend ein Siliziumsubstrat (1), eine zur Lichteinkopplung ausgebildete Vorderseite (2) und eine Rückseite (3),
   **dadurch gekennzeichnet,**
   **dass** die Vorderseite zumindest in einem Teilbereich eine Vorderseitentextur aufweist, weiche entlang einer Raumrichtung A periodisch ist mit einer Periodenlänge größer 1 $\mu$m und
   die Rückseite zumindest in einem Teilbereich eine Rückseitentextur aufweist, welche entlang einer Raumrichtung B periodisch ist mit einer Periodenlänge kleiner 1 $\mu$m,
wobei die Raumrichtung A in einem Winkel zwischen 80° und 100° Grad zu der Raumrichtung B steht.

2. Solarzelle nach Anspruch 1,
   **dadurch gekennzeichnet,**
   **dass** die Raumrichtung A in einem Winkel zwischen 85° und 95° Grad, vorzugsweise im rechten Winkel zu der Raumrichtung B steht.

3. Solarzelle nach mindestens einem der vorangegangenen Ansprüchen,
   **dadurch gekennzeichnet,**
   **dass** die Vorderseitentextur in einer zu der Raumrichtung A senkrecht stehenden Raumrichtung A' keine Periodizität oder eine Periodizität mit einer Periodenlänge von mindestens 30 $\mu$m, vorzugsweise mindestens 50 $\mu$m aufweist und/oder
   **dass** in der Raumrichtung A' sich die Höhe der Vorderseitentextur um nicht mehr als 2 $\mu$m ändert, vorzugsweise, dass in der Raumrichtung A' die Vorderseitentextur eine in etwa konstante Höhe aufweist.

4. Solarzelle nach mindestens einem der vorangegangenen Ansprüchen,
   **dadurch gekennzeichnet,**
   **dass** die Rückseitentextur in einer zu der Raumrichtung B senkrecht stehenden Raumrichtung B' keine Periodizität oder eine Periodizität mit einer Periodenlänge von mindestens 5 $\mu$m, vorzugsweise mindestens 10 $\mu$m, im Weiteren vorzugsweise mindestens 30 $\mu$m, insbesondere mindestens 50 $\mu$m aufweist und/oder
   **dass** in der Raumrichtung B' sich die Höhe der Rückseitentextur um nicht mehr als 50 nm ändert, vorzugsweise, dass in der Raumrichtung B' die Rückseitentextur eine in etwa konstante Höhe aufweist und/oder dass die Rückseitentextur in Raumrichtung B' keine Periodizität oder eine Periodizität mit einer Periodenlänge aufweist, die mindestens dem 5-fachen, vorzugsweise mindestens dem 10-fachen, im Weiteren vorzugsweise mindestens dem 15-fachen der Periodenlänge der Rückseitentextur in Raumrichtung B entspricht.

5. Solarzelle nach mindestens einem der vorangegangenen Ansprüchen,
   **dadurch gekennzeichnet,**
   **dass** die Vorderseitentextur eine sich in einer senkrecht zur Raumrichtung A stehenden Raumrichtung A' linear erstreckende Textur ist und/oder die Rückseitentextur eine sich in einer senkrecht zur Raumrichtung B stehenden Raumrichtung B' linear erstreckende Textur ist, vorzugsweise,
   **dass** die Vorderseitentextur in Raumrichtung A' und/oder die Rückseitentextur in Raumrichtung B' jeweils eine in etwa konstante Querschnittsfläche und in etwa konstante Querschnittsflächenform aufweisen.

6. Solarzelle nach mindestens einem der vorangegangenen Ansprüche,
   **dadurch gekennzeichnet,**
   **dass** die Vorderseitentextur eine refraktive Textur und/oder die Rückseitentextur eine diffraktive Textur ist.

7. Solarzelle nach mindestens einem der vorangegangenen Ansprüche,
   **dadurch gekennzeichnet,**
   **dass** die Periodizität der Vorderseitentextur größer 3 μm, vorzugsweise größer 5 μm ist und/oder
   **dass** die Periodizität der Rückseitentextur kleiner 800 nm, vorzugsweise kleiner 600 nm ist.

8. Solarzelle nach mindestens einem der vorangegangenen Ansprüche,
   **dadurch gekennzeichnet,**
   **dass** die Solarzelle ein monokristallines Siliziumsubstrat (1) umfasst, an dessen Vorderseite (2) die Vorderseitentextur ausgebildet ist und
   **dass** die Vorderseitentextur dreieckige Querschnittsflächen aufweist oder
   **dass** die Solarzelle ein multikristallines Siliziumsubstrat (1) umfasst, an dessen Vorderseite (2) die Vorderseitentextur ausgebildet ist und
   **dass** die Querschnittsflächen der Vorderseitentextur parabolische Begrenzungen aufweisen oder Kreissegmente, vorzugsweise Halbkreise, sind.

9. Solarzelle nach mindestens einem der vorangegangenen Ansprüche,
   **dadurch gekennzeichnet,**
   **dass** die Rückseitentextur einen zumindest näherungsweise sägezahnförmigen oder treppenförmigen Querschnitt aufweist
   oder
   **dass** die Rückseitentextur einen zinnenförmigen Querschnitt aufweist.

10. Solarzelle nach mindestens einem der vorangegangenen Ansprüche,
    **dadurch gekennzeichnet,**
    **dass** die Vorderseite (2) eine oder mehrere optische Schichten mit jeweils einer Dicke kleiner 1 μm aufweist, zur Erhöhung der Lichteinkopplung an der Vorderseite (2).

11. Solarzelle nach mindestens einem der vorangegangenen Ansprüche,
    **dadurch gekennzeichnet,**
    **dass** die Vorderseitentextur an der Vorderseite (2) und/oder die Rückseitentextur an der Rückseite (3) des Siliziumsubstrates ausgebildet sind.

12. Solarzelle nach mindestens einem der vorangegangenen Ansprüche,
    **dadurch gekennzeichnet,**
    **dass** an der Rückseite (3) eine Rückseitenschicht, vorzugsweise eine dielektrische Schicht, auf die Rückseitentextur aufgebracht ist, wobei die Rückseitentextur vollständig von der dielektrischen Schicht bedeckt ist, insbesondere,
    **dass** auf die Rückseitenschicht eine Metallschicht aufgebracht ist, vorzugsweise,
    **dass** die Metalischicht eine Mehrzahl von elektrisch leitenden Verbindungen zu der Rückseitentextur aufweist.

13. Verfahren zur Herstellung einer Solarzelle, umfassend ein Halbleitersubstrat mit einer Vorder- und einer Rückseite (3),
    folgende Verfahrensschritte umfassend:

    A Erzeugen einer Vorderseitentextur zumindest an einem Teilbereich der Vorderseite, wobei die Vorderseitentextur entlang einer Raumrichtung A periodisch ist mit einer Periodenlänge größer 1 μm,
    B Erzeugen einer Rückseitentextur zumindest an einem Teilbereich der Rückseite, welche entlang einer Raumrichtung B periodisch ist mit einer Periodenlänge kleiner 1 μm,
    wobei die Raumrichtung A in einem Winkel zwischen 80° und 100° Grad zu der Raumrichtung B steht.

14. Verfahren nach Anspruch 13,
    **dadurch gekennzeichnet,**
    **dass** die Erzeugung der Rückseitentextur in Verfahrensschritt B folgende Verfahrensschritte umfasst:

    B1 Aufbringen einer ätzresistenten Maskierungsschicht,
    B2 Strukturieren der Maskierungsschicht mittels eines Prägeverfahrens und
    B3 Ätzen der nicht durch die Maskierungsschicht bedeckten Bereiche der Rückseite (3).

15. Verfahren nach mindestens einem der Ansprüche 13 bis 14,
    **dadurch gekennzeichnet,**
    **dass** nach Schritt B eine Rückseitenschicht, vorzugsweise eine dielektrische Schicht auf die Rückseitentextur und diese vollständig bedeckend aufgebracht wird,
    und/oder
    **dass** auf die Rückseite (3) oder die Rückseite (3) bedeckende Schichten eine Metallschicht aufgebracht wird und die Metallschicht an einer Mehrzahl von Punkten elektrisch leitend mit dem Halbleitersubstrat verbunden wird, vorzugsweise mittels lokalem Aufschmelzen durch Lasereinstrahlung.

**Claims**

1. Solar cell,
comprising a silicon substrate (1), a front side (2) configured for coupling in light, and a rear side (3),
**characterised in that**
the front side has, at least in a sub-region, a front-side texture which is periodic along a spatial direction A with a period length greater than 1 μm, and
the rear side has, at least in a sub-region, a rear-side texture which is periodic along a spatial direction B with a period length of less than 1 μm,
the spatial direction A being at an angle of between 80° and 100° to the spatial direction B.

2. Solar cell according to claim 1,
**characterised in that**
the spatial direction A is at an angle of between 85° and 95° to the spatial direction B, preferably at a right angle thereto.

3. Solar cell according to at least one of the preceding claims,
**characterised in that**
the front-side texture, in a spatial direction A' perpendicular to the spatial direction A, has no periodicity or has a periodicity with a period length of at least 30 μm, preferably at least 50 μm, and/or,
in the spatial direction A', the height of the front-side texture varies by not more than 2 μm, the front-side texture preferably being of approximately constant height in the spatial direction A'.

4. Solar cell according to at least one of the preceding claims,
**characterised in that**
the rear-side texture, in a spatial direction B' perpendicular to the spatial direction B, has no periodicity or has a periodicity with a period length of at least 5 μm, preferably at least 10 μm, furthermore preferably at least 30 μm, especially at least 50 μm, and/or,
in the spatial direction B', the height of the rear-side texture varies by not more than 50 nm, the rear-side texture preferably being of approximately constant height in the spatial direction B' , and/or
the rear-side texture, in the spatial direction B', has no periodicity or has a periodicity with a period length that corresponds to at least 5 times, preferably at least 10 times, furthermore preferably at least 15 times, the period length of the rear-side texture in the spatial direction B.

5. Solar cell according to at least one of the preceding claims,
**characterised in that**
the front-side texture is a texture that extends linearly in a spatial direction A' perpendicular to the spatial direction A and/or the rear-side texture is a texture that extends linearly in a spatial direction B' perpendicular to the spatial direction B, preferably the front-side texture in the spatial direction A' and/or the rear-side texture in the spatial direction B' have in each case an approximately constant cross-sectional area and an approximately constant cross-sectional surface shape.

6. Solar cell according to at least one of the preceding claims,
**characterised in that**
the front-side texture is a refractive texture and/or the rear-side texture is a diffractive texture.

7. Solar cell according to at least one of the preceding claims,
**characterised in that**
the periodicity of the front-side texture is greater than 3 μm, preferably greater than 5 μm, and/or the periodicity of the rear-side texture is less than 800 nm, preferably less than 600 nm.

8. Solar cell according to at least one of the preceding claims,
**characterised in that**
the solar cell comprises a monocrystalline silicon substrate (1), on the front side (2) of which the front-side texture is formed, and
the front-side texture has triangular cross-sectional surfaces,
or
the solar cell comprises a multicrystalline silicon substrate (1), on the front side (2) of which the front-side texture is formed, and
the cross-sectional surfaces of the front-side texture have parabolic boundaries or are circular segments, preferably semicircles.

9. Solar cell according to at least one of the preceding claims,
**characterised in that**
the rear-side texture has an at least approximately sawtooth-shaped or step-like cross-section
or
the rear-side texture has a crenellated cross-section.

10. Solar cell according to at least one of the preceding claims,
**characterised in that**
the front side (2) has one or more optical layers, each having a thickness of less than 1 μm, for increasing the coupling-in of light at the front side (2).

11. Solar cell according to at least one of the preceding claims,
**characterised in that**
the front-side texture is formed on the front side (2) and/or the rear-side texture is formed on the rear side (3) of the silicon substrate.

12. Solar cell according to at least one of the preceding claims,
    **characterised in that**,
    on the rear side (3), a rear-side layer, preferably a dielectric layer, is applied to the rear-side texture, the rear-side texture being entirely covered by the dielectric layer,
    especially
    a metal layer is applied to the rear-side layer, preferably the metal layer has a plurality of electrically conductive connections to the rear-side texture.

13. Process for the production of a solar cell, comprising a semiconductor substrate having a front side and a rear side (3),
    comprising the following process steps:

    A creation of a front-side texture on at least a sub-region of the front side, which front-side texture is periodic along a spatial direction A with a period length greater than 1 μm,
    B creation of a rear-side texture on at least a sub-region of the rear side, which rear-side texture is periodic along a spatial direction B with a period length of less than 1 μm,
    the spatial direction A being at an angle of between 80° and 100° to the spatial direction B.

14. Process according to claim 13,
    **characterised in that**
    the creation of the rear-side texture in process step B comprises the following process steps:

    B1 application of an etch-resistant masking layer,
    B2 structuring of the masking layer by means of an embossing process and
    B3 etching of the regions of the rear side (3) not covered by the masking layer.

15. Process according to at least one of claims 13 and 14,
    **characterised in that**
    after step B a rear-side layer, preferably a dielectric layer, is applied to the rear-side texture so as to entirely cover the latter,
    and/or
    a metal layer is applied to the rear side (3) or to layers covering the rear side (3) and the metal layer is brought into electrically conductive connection with the semiconductor substrate at a plurality of points, preferably by local melting by means of laser irradiation.

**Revendications**

1. Cellule solaire,
   comprenant un substrat de silicium (1), une face avant (2) conçue pour le couplage de lumière et une face arrière (3),
   **caractérisée en ce**
   **que** la face avant présente au moins dans une zone partielle une texture de face avant qui est périodique suivant une direction spatiale A avec une longueur de période supérieure à 1 μm et
   la face arrière présente au moins dans une zone partielle une texture de face arrière qui est périodique suivant une direction spatiale B avec une longueur de période inférieure à 1 μm,
   la direction spatiale A formant un angle compris entre 80° et 100° avec la direction spatiale B.

2. Cellule solaire selon la revendication 1,
   **caractérisée en ce**
   **que** la direction spatiale A forme un angle compris entre 85° et 95°, de préférence un angle droit avec la direction spatiale B.

3. Cellule solaire selon au moins l'une des revendications précédentes,
   **caractérisée en ce**
   **que** dans une direction spatiale A' perpendiculaire à la direction spatiale A, la texture de face avant ne présente aucune périodicité ou présente une périodicité avec une longueur de période d'au moins 30 μm, de préférence d'au moins 50 μm, et/ou
   **que** dans la direction spatiale A', la hauteur de la texture de face avant ne varie pas de plus de 2 μm, de préférence que dans la direction spatiale A', la texture de face avant présente une hauteur sensiblement constante.

4. Cellule solaire selon au moins l'une des revendications précédentes,
   **caractérisée en ce**
   **que** dans une direction spatiale B' perpendiculaire à la direction spatiale B, la texture de face arrière ne présente aucune périodicité ou présente une périodicité avec une longueur de période d'au moins 5 μm, de préférence d'au moins 10 μm, davantage de préférence d'au moins 30 μm, en particulier d'au moins 50 μm et/ou que dans la direction spatiale B', la hauteur de la texture de face arrière ne varie pas de plus de 50 nm, de préférence que dans la direction spatiale B', la texture de face arrière présente une hauteur sensiblement constante et/ou que dans la direction spatiale B', la texture de face arrière ne présente aucune périodicité ou présente une périodicité avec une longueur de période qui correspond à au moins 5 fois, de préférence à au moins 10 fois, davantage de préférence à au moins 15 fois la longueur de période de la texture de face arrière dans

**5.** Cellule solaire selon au moins l'une des revendications précédentes, **caractérisée en ce que** la texture de face avant est une texture qui s'étend linéairement dans une direction spatiale A' perpendiculaire à la direction spatiale A et/ou la texture de la face arrière est une texture qui s'étend linéairement dans une direction spatiale B' perpendiculaire à la direction spatiale B, de préférence **que** la texture de face avant et/ou la texture de face arrière présentent, respectivement dans la direction spatiale A' et dans la direction spatiale B', une surface de section transversale sensiblement constante et une forme de surface de section transversale sensiblement constante.

**6.** Cellule solaire selon au moins l'une des revendications précédentes, **caractérisée en ce que** la texture de face avant est une texture réfractive et/ou la texture de face arrière une texture diffractive.

**7.** Cellule solaire selon au moins l'une des revendications précédentes, **caractérisée en ce que** la périodicité de la texture de face avant est supérieure à 3 µm, de préférence supérieure à 5 µm et/ou **que** la périodicité de la texture de face arrière est inférieure à 800 nm, de préférence inférieure à 600 nm.

**8.** Cellule solaire selon au moins l'une des revendications précédentes, **caractérisée en ce que** la cellule solaire comprend un substrat de silicium monocristallin (1) sur la face avant (2) duquel la texture de face avant est formée et **que** la texture de face avant présente des surfaces de section transversale triangulaires ou **que** la cellule solaire comprend un substrat de silicium multicristallin (1) sur la face avant (2) duquel la texture de face avant est formée et **que** les surfaces de section transversale de la texture de face avant présentent des limites paraboliques ou sont des segments de cercle, de préférence des demi-cercles.

**9.** Cellule solaire selon au moins l'une des revendications précédentes, **caractérisée en ce que** la texture de face arrière présente une section transversale au moins approximativement en dents de scie ou en marches d'escalier ou

**que** la texture de face arrière présente une section transversale crénelée.

**10.** Cellule solaire selon au moins l'une des revendications précédentes, **caractérisée en ce que** la face avant (2) présente une ou plusieurs couches optiques d'une épaisseur chaque fois inférieure à 1 µm pour augmenter le couplage de lumière sur la face avant (2).

**11.** Cellule solaire selon au moins l'une des revendications précédentes, **caractérisée en ce que** la texture de face avant est formée sur la face avant (2) et/ou la texture de face arrière sur la face arrière (3) du substrat de silicium.

**12.** Cellule solaire selon au moins l'une des revendications précédentes, **caractérisée en ce que** sur la face arrière (3), une couche de face arrière, de préférence une couche diélectrique, est appliquée sur la texture de face arrière, la texture de face arrière étant entièrement recouverte par la couche diélectrique, en particulier **qu'**une couche métallique est appliquée sur la couche de face arrière, de préférence que la couche métallique présente une pluralité de liaisons électroconductrices avec la texture de face arrière.

**13.** Procédé de fabrication d'une cellule solaire, comprenant un substrat semi-conducteur avec une face avant et une face arrière (3), lequel procédé comprend les étapes suivantes :

A production d'une texture de face avant au moins sur une zone partielle de la face avant, laquelle texture de face avant est périodique suivant une direction spatiale A avec une longueur de période supérieure à 1 µm, B production d'une texture de face arrière au moins sur une zone partielle de la face arrière, laquelle texture de face arrière est périodique suivant une direction spatiale B avec une longueur de période inférieure à 1 µm, la direction spatiale A formant un angle compris entre 80° et 100° avec la direction spatiale B.

**14.** Procédé selon la revendication 13, **caractérisé en ce que** la production de la texture de face arrière à l'étape de procédé B comprend les étapes de procédé suivantes :

B1 application d'une couche de masquage résistante à la gravure,

B2 structuration de la couche de masquage au moyen d'un procédé d'estampage et
B3 gravure des zones de la face arrière (3) non recouvertes par la couche de masquage.

15. Procédé selon au moins l'une des revendications 13 à 14,
**caractérisé en ce**
**qu'**après l'étape B, une couche de face arrière, de préférence une couche diélectrique, est appliquée sur la texture de face arrière de façon à la recouvrir entièrement,
et/ou
**qu'**une couche métallique est appliquée sur la face arrière (3) ou sur les couches recouvrant la face arrière (3) et la couche métallique est reliée en une pluralité de points de manière électroconductrice au substrat semi-conducteur, de préférence au moyen d'une fusion locale par irradiation par laser.

# Figur 1

# Figur 2

a)

b)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19522539 A1
- US 2004021062 A
- US 4608451 A
- US 4620364 A
- US 5080725 A
- WO 200810063 A
- US 4731155 A
- DE 10046170 A1
- US 5468652 A
- EP 985233 A

**In der Beschreibung aufgeführte Nicht-Patentliteratur**

- **C. HEINE ; R. H. MORF.** Submicrometer gratings for Solar energy applications. *Applied Optics,* Mai 1995, vol. 34 (14